# EUROPEAN PATENT SPECIFICATION

(11) **EP 1 825 507 B1**
(45) Date of publication and mention of the grant of the patent: **28.09.2011**
(21) Application number: 05808203.3
(22) Date of filing: 01.11.2005
(51) Int. Cl.: H01L 21/78, H01L 21/3065

(54) **INCREASING DIE STRENGTH BY ETCHING DURING OR AFTER DICING**
VERGRÖSSERN DER CHIPBELASTUNGSFÄHIGKEIT DURCH ÄTZEN WÄHREND ODER NACH DES ZERTEILENS
AUGMENTATION DE LA RESISTANCE DES PUCES PAR ATTAQUE PENDANT OU APRES LE DECOUPAGE EN PUCES

(30) Priority: 01.11.2004 GB 0424195
(43) Date of publication of application: 29.08.2007
(73) Proprietor: Electro Scientific Industries, Inc., Portland, OR 97229 (US)
(72) Inventor: BOYLE, Adrian, Country Kildare (IE); GILLEN, David, Dublin 3 (IE); DUNNE, Kali, County Roscommon (IE); FERNANDES GOMEZ, Eva, Dublin 1 (IE); TOFTNESS, Richard, Loveland, CO 80537-7815 (US)
(74) Representative: Want, Clifford James
(86) International application number: PCT/EP2005/011671
(87) International publication number: WO 2006/048230

(56) References cited:
- WO-A-03/078091
- US-A1- 2004 072 388
- PATENT ABSTRACTS OF JAPAN vol. 1995, no. 11, 26 December 1995 (1995-12-26) -& JP 07 201784 A (FUJITSU LTD), 4 August 1995 (1995-08-04)
- PATENT ABSTRACTS OF JAPAN vol. 015, no. 438 (E-1130), 8 November 1991 (1991-11-08) -& JP 03 183153 A (FUJITSU LTD), 9 August 1991 (1991-08-09)
- BAHREYNI BEHRAAD ET AL: "Investigation and simulation of XeF2 isotropic etching of silicon" JOURNAL OF VACUUM SCIENCE AND TECHNOLOGY A. VACUUM, SURFACES AND FILMS, AMERICAN INSTITUTE OF PHYSICS, NEW YORK, NY, US, vol. 20, no. 6, November 2002 (2002-11), pages 1850-1854, XP012006208 ISSN: 0734-2101

## Description

This invention relates to increasing die strength by etching during or after dicing a semiconductor wafer.

Etching of semiconductors such as silicon with spontaneous etchants is known with a high etch selectivity to a majority of capping, or encapsulation, layers used in the semiconductor industry. By spontaneous etchants will be understood etchants which etch without a need for an external energy source such as electricity, kinetic energy or thermal activation. Such etching is exothermic so that more energy is released during the reaction than is used to break and reform inter-atomic bonds of the reactants. US 6,498,074 discloses a method of dicing a semiconductor wafer part way through with a saw, laser or masked etch from an upper side of the wafer to form grooves at least as deep as an intended thickness of die to be singulated from the wafer. A backside of the wafer, opposed to the upper side, is dry etched, for example with an atmospheric pressure plasma etch of CF₄, past a point at which the grooves are exposed to remove damage and resultant stress from sidewalls and bottom edges and corners of the die, resulting in rounded edges and corners. Preferably a protective layer, such as a polyimide, is used after grooving to hold the die together after singulation and during etching and to protect the circuitry on the top surface of the wafer from etchant passing through the grooves.

However, in order to etch from the backside of the wafer it is necessary to remount the wafer, in, for example, a vortex non-contact chuck, after grooving the upper surface, in order to etch the wafer from an opposite side from that from which the wafer is grooved.

JP 07 201784 discloses smoothing sidewalls of die by etching with folic acid using a resist film as a mask, by the removal of Si fragments generated by a grindstone from the sidewalls or by smoothing the sidewalls sufficiently to prevent the fragments adhering to the walls.

JP 03 183153 discloses masking a partially diced wafer and then etching away a chipped portion of a sidewall that occurs at an upper surface of a sawn wafer and avoiding chipping at a lower surface by only partially dicing the wafer with a saw and removing a final portion of a lane between chips by etching.

US 2004/072388 discloses a method of partially dicing a wafer from a backside and stopping short of the front side. The wafer is then chemically etched from the rear to singulate the chips. Avoidance of fractures and cutting and grinding distortion layers results in an increased anti-breakage strength of the chips. Thus US 2004/072388 teaches away from cutting from a front side, because such a method results in fractures in the vicinity of the active layer.

Bahreyni Behraad et al: "Investigation and simulation of XeF2 isotropic etching of silicon" J. Vacuum Science and Technology 20(6), Nov. 2002, pp 1850-1854 discloses an investigation and simulation of XeF₂ isotropic etching of silicon. The disclosure is particularly directed to a discussion of trenching, i.e. deeper etching at a side of an etch feature compared with etching in the middle of a feature and loading, i.e. a reduction in etch depth that adjacent etched regions impose on etch profiles. The disclosure is of etching through a mask. The paper acknowledges that direct gaseous isotropic etching of Si i with XeF₂, BrF₃ and ClF₃ is known, and, because the etching is isotropic, teaches that gas phase etching is suitable only where accuracy of etching is not critical, as in the removal of sacrificial layers.

It is an object of the present invention at least to ameliorate the aforesaid shortcoming in the prior art.

According to a first aspect of the present invention there is provided a method of dicing a semiconductor wafer having an active layer according to claim 1 comprising the steps of: mounting the semiconductor wafer on a carrier with the active layer away from the carrier; at least partially dicing the semiconductor wafer on the carrier from a major surface of the semiconductor wafer to form an at least partially diced semiconductor wafer; and etching the at least partially diced semiconductor wafer on the carrier from the said major surface with a spontaneous etchant to remove sufficient semiconductor material from a die produced from the at least partially diced semiconductor wafer to improve flexural bend strength of the die characterised in that remaining portion of the die are masked from the spontaneous etchant by portion of the active layer on the die characterized in that remaining portions of the die are masked from the spontaneous etchant by portions of the active layer on the die.

Conveniently, the step of at least partially dicing the semiconductor wafer comprises dicing the semiconductor wafer completely through the semiconductor wafer; and the step of etching the semiconductor wafer comprises etching sidewalls of the die, remaining portions of the die being masked from the spontaneous etchant by portions of the active layer on the die.

Alternatively, the step of at least partially dicing the semiconductor wafer comprises partially dicing the semiconductor wafer along dicing lanes to leave portions of semiconductor material bridging the dicing lanes; and the step of etching the semiconductor wafer comprises etching sidewalls of the dicing lanes and etching away the portions of semiconductor material bridging the dicing lanes to singulate the die.

Advantageously, the semiconductor wafer is a silicon wafer.

The step of etching with a spontaneous etchant comprises etching with xenon difluoride.

The step of etching with a spontaneous etchant comprises providing an etching chamber and etching the semiconductor wafer within the etching chamber.

Advantageously, the step of etching with a spontaneous etchant within the etching chamber comprises cyclically supplying the chamber with spontaneous etchant and purging the etching chamber of spontaneous etchant for a plurality of cycles during etching of the semiconductor wafer.

The invention will now be described, by way of example, with reference to the accompanying drawings in which:
Figure 1 is a schematic flow diagram of a first embodiment of the invention comprising active side up dicing followed by spontaneous etching;
Figure 2 is a schematic flow diagram of a second embodiment of the invention comprising active face up partial dicing followed by die release by spontaneous etching;
Figure 3 is a graph of survival probability as ordinates versus die strength as abscissa of a laser-cut control wafer and wafers etched to various extents according to the invention as measured by a 3-point test;
Figure 4 is a graph of survival probability as ordinates versus die strength as abscissa of a saw-cut control wafer and wafers etched to various extents according to the invention as measured by a 3-point test;
Figure 5 is a graph of survival probability as ordinates versus die strength as abscissa of a laser-cut control wafer and wafers etched to various extents according to the invention as measured by a 4-point test;
Figure 6 is a graph of survival probability as ordinates versus die strength as abscissa of a saw-cut control wafer and wafers etched to various extents according to the invention as measured by a 4-point test;
Figure 7 shows micrographs of sidewalls of a laser-cut control wafer and of laser-cut wafers etched to various extents according to the invention; and
Figure 8 is of micrographs of sidewalls of a saw-cut control wafer and of saw-cut wafers etched to various extents according to the invention.

In the Figures like reference numerals denote like parts.

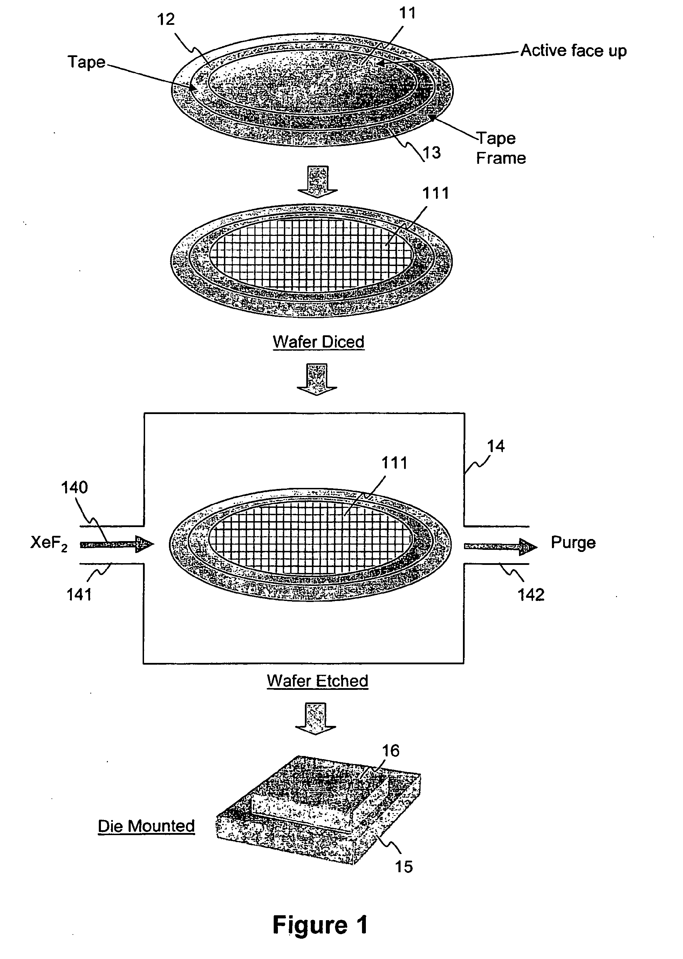

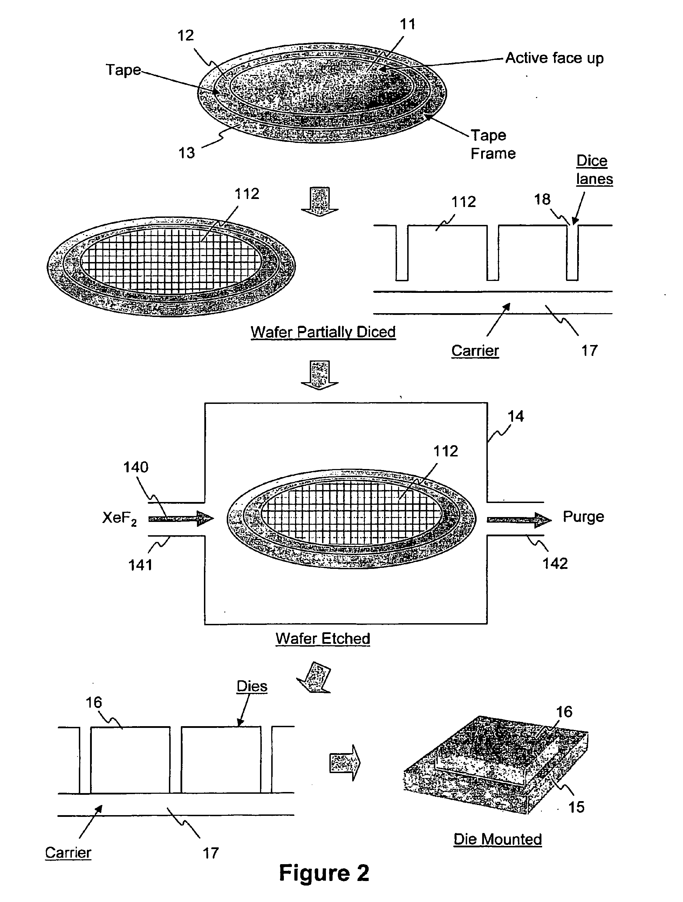

referring to Figures 1 and 2, a silicon wafer 11 on a standard dicing tape 12 and tape frame 13 is mounted on a carrier, not shown. The wafer is diced using a laser or a mechanical saw on the carrier to produce a diced wafer 111. The laser may be a diode-pumped solid-state laser, a mode-locked laser or any other laser suitable for machining the semiconductor and other materials of the wafer. Suitable laser wavelengths may be selected from infrared to ultraviolet wavelengths.

The diced wafer 111 is placed on the carrier in a chamber 14, the chamber having an inlet port 141 and an outlet port 142. Cycles of xenon difluoride (XeF₂), or any other spontaneous etchant of silicon, are input through the inlet port 141 and purged through the outlet port 142 for a predetermined number of cycles each of a predetermined duration. Alternatively, the etching may be carried out as a continuous process, but this has been found to be less efficient in terms of etch rate and etchant usage. The dies are then released from the tape 12 and mounted onto a die pad 15 or another die to form a mounted die 16.

Referring to Figure 1, in a first embodiment of the invention, a wafer 11, with an active layer uppermost, is diced followed by spontaneous etching. The wafer 11 is mounted active face up on a wafer carrier on a tape 12 and a tape frame 13, that is, with the active layer away from the carrier. The wafer is diced with a mechanical dicing saw or a laser dicing saw on the carrier to form an active side up, diced wafer 111. The diced wafer 111 is placed face up in an etching chamber 14 and a spontaneous etchant 140 of silicon is input into the chamber 14 through the inlet port 141 to come in contact with the diced wafer 111 for a predefined period. The etchant can be, but is not limited to, XeF₂ and can be either a gas or liquid. The diced wafer 111 is held in place in the chamber 14 by the wafer carrier, not shown, which can be made of any flexible or inflexible material that holds the wafer in place either through the use of an adhesive layer or by mechanical means such as physical, electrical or vacuum clamping. The wafer carrier can be opaque or optically transparent. After etching, singulated etched dies 16 are removed from the carrier and mounted onto a die pad 15 or another die. In this embodiment, the active layer acts as a mask to the spontaneous etchant and only the sidewalls of the dies are etched to remove a layer of silicon. The etching of the sidewall changes the physical nature of the sidewall thereby increasing the average die strength, as measured to destruction with a three-point or four-point test.

Referring to Figure 2, in a second embodiment of the invention, a wafer 11, with an active layer uppermost is mounted active side up on a tape 12 and tape frame 13 on a wafer carrier 17. The wafer carrier 17 can be made of any optically transparent flexible or inflexible material that is suitable for holding the wafer in place either through the use of an adhesive layer or by mechanical means such as mechanical, electrical or vacuum clamping. The wafer 11 is partially diced through along dice lanes 18 with a mechanical dicing saw or a laser dicing saw to form a partially diced wafer 112. The partially diced wafer 112 is placed face up, on the carrier 17, in an etching chamber 14 to come into contact with a spontaneous etchant 140 of silicon until the etchant 140 has etched away a remaining portion of silicon in the dice lanes. The etchant can be, but is not limited to, XeF₂ and can be either a gas or liquid. As well as by a change in physical nature of the sidewall, die strength is also enhanced because the dies are diced substantially simultaneously, avoiding any stress build up which may occur in conventionally diced wafers.

The process of the invention provides the advantages over other etch processes, such as chemical or plasma etching, of being a fully integrated, dry, controllable, gas process, so that no specialist wet chemical handling is required, and clean, safe and user-friendly materials are used in a closed handling system that lends itself well to automation. Moreover, since spontaneous etching may be carried out in parallel with dicing, cycle time is of the order of dicing process time, so that throughput is not restricted. Furthermore, the invention uses a tape-compatible etch process which is also compatible with future wafer mounts, such as glass. In addition, no plasma is used, as in the prior art, which might otherwise induce electrical damage on sensitive electrical devices. Finally, the invention provides an inexpensive process which, used with laser dicing, provides a lower cost dicing process than conventional dicing processes.

### EXAMPLE

Ten 125mm diameter 180µm thick silicon wafers were coated with standard photoresist. The wafers were split into two groups as shown in Table 1 with five wafers undergoing laser dicing and five wafers undergoing dicing by mechanical saw.

**Table 1. Wafer description**

| **Wafer number** | **Dicing Process** | **Etch depth (µm)** | | **Wafer number** | **Dicing process** | **Etch depth (µm)** |
|---|---|---|---|---|---|---|
| 1 | Laser | Not etched | | 6 | Saw | Not etched |
| 2 | | 2 | | 7 | | 2 |
| 3 | | 3 | | 8 | | 3 |
| 4 | | 4 | | 9 | | 4 |
| 5 | | 25 | | 10 | | 25 |

After dicing the wafers were placed in a chamber and etched with XeF₂ for a predetermined period of time. After this period the chamber was evacuated and purged. This etch, evacuate and purge cycle was repeated for a set number of times to remove a predetermined thickness of silicon. The numbers of cycles used are given in Table 2.

**Table 2. Etching parameters**

| **Etch depth (µm)** | **Number of cycles** | **Time per cycle (sec)** |
|---|---|---|
| Not etched | -- | -- |
| 2 µm | 8 | 10 |
| 3 µm | 12 | 10 |
| 4 µm | 16 | 10 |
| 25 µm | 100 | 10 |

After the wafers had been etched, the die strength of each wafer was measured using 3-point and 4-point flexural bend strength testing.

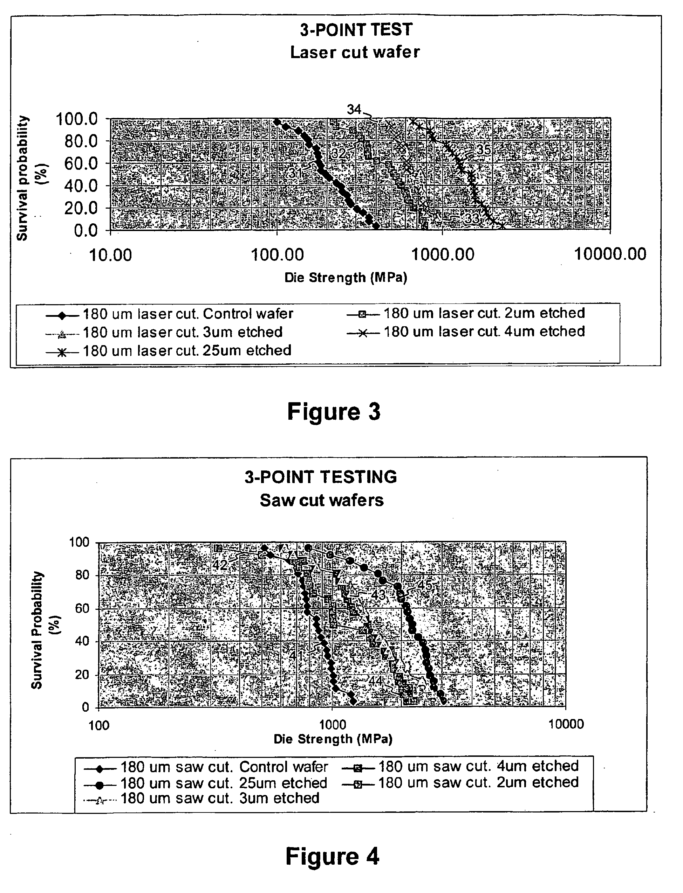

The results for 3-point die strength testing are listed in Table 3 for laser-cut wafers and Table 4 for saw-cut wafers. Corresponding graphs comparing the survival probability for the control wafer with the four different etch depths used are shown in Figure 3 for laser-cut wafers, in which line 31 relates to an un-etched wafer, line 32 an etch depth of 2 µm, line 33 an etch depth of 3 µm, line 34 an etch depth of 4 µm and line 35 an etch depth of 25 µm and in Figure 4 for saw-cut wafers in which line 41 relates to an un-etched wafer, line 42 an etch depth of 2 µm, line 43 an etch depth of 3 µm, line 44 an etch depth of 4 µm and line 45 an etch depth of 25 µm. It can be seen that for both laser-cut and saw-cut wafers the flexural strength as measured by a 3-point test generally increases with etch depth.

**Table3. Laser cut wafers. 3-Point Die Strength Test**

| **Normalised Die Strength (MPa) for Xise laser diced wafers** | | | | | |
|---|---|---|---|---|---|
| | **Control wafer** | **2 µm etched** | **3 µm etched** | **4 µm etched** | **25 µm etched** |
| **Average (MPa)** | 223 | 506 | 697 | 658 | 1381 |
| **Std Dev (MPa)** | 83 | 178 | 162 | 131 | 417 |
| **Max (MPa)** | 404 | 799 | 1077 | 920 | 2279 |
| **Min (MPa)** | 100 | 221 | 446 | 403 | 663 |
| **Range (MPa)** | 304 | 578 | 632 | 518 | 1616 |
| **Coeff. of variance** | 0.37 | 0.35 | 0.23 | 0.20 | 0.30 |

**Table 4. Saw cut wafers. 3-Point Die Strength Test**

| **Normalised Die Strength (MPa) for mechanical saw cut wafers** | | | | | |
|---|---|---|---|---|---|
| | **Control wafer** | **2 µm etched** | **3 µm etched** | **4 µm etched** | **25 µm etched** |
| **Average (MPa)** | 861 | 1308 | 1585 | 1427 | 2148 |
| **Std Dev (MPa)** | 181 | 593 | 623 | 457 | 601 |
| **Max (MPa)** | 1245 | 2250 | 2894 | 2119 | 3035 |
| **Min (MPa)** | 512 | 321 | 622 | 617 | 790 |
| **Range (MPa)** | 733 | 1929 | 2272 | 1502 | 2246 |
| **Coeff. of variance** | 0.21 | 0.45 | 0.39 | 0.39 | 0.28 |

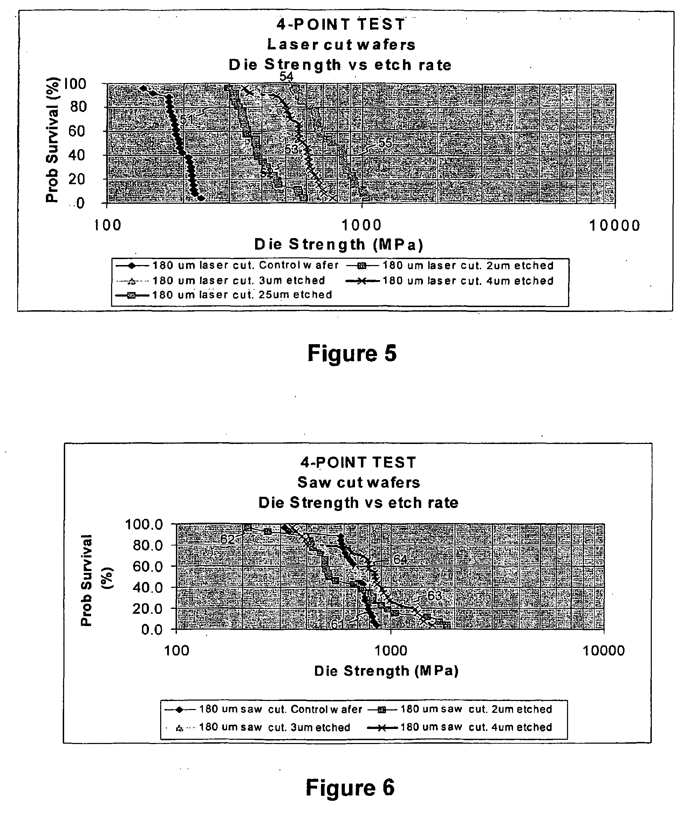

The results for 4-point die strength testing are listed in Tables 5 and 6. Corresponding graphs comparing the survival probability for the control wafer and the four different etch tests are shown in Figures 5 for laser-cut wafers, in which line 51 relates to an un-etched wafer, line 52 an etch depth of 2 µm, line 53 an etch depth of 3 µm, line 54 an etch depth of 4 µm and line 55 an etch depth of 25 µm and in Figure 6 for saw-cut wafers in which line 61 relates to an un-etched wafer, line 62 an etch depth of 2 µm, line 63 an etch depth of 3 µm, and line 64 an etch depth of 4 µm. It can be seen that for both laser-cut and saw-cut wafers the flexural strength as measured by a 4-point test generally increases with etch depth.

**Table 5. Laser cut wafers. 4-Point Die Strength Test**

| **Normalised Die Strength (MPa) for Xise laser diced wafers** | | | | | |
|---|---|---|---|---|---|
| | **Control wafer** | **2 µm etched** | **3 µm etched** | **4 µm etched** | **25 µm etched** |
| **Average (MPa)** | 194 | 394 | 551 | 574 | 770 |
| **Std Dev (MPa)** | 23 | 81 | 109 | 101 | 155 |
| **Max (MPa)** | 234 | 588 | 743 | 762 | 1043 |
| **Min (MPa)** | 139 | 296 | 370 | 342 | 543 |
| **Range (MPa)** | 95 | 291 | 373 | 419 | 500 |
| **Coeff of variance** | 0.12 | 0.20 | 0.20 | 0.18 | 0.20 |

**Table 6. Saw cut wafers. 4-Point Die Strength Test**

| **Normalised Die Strength (MPa) for mechanical saw diced wafers** | | | | | |
|---|---|---|---|---|---|
| | **Control wafer** | **2 µm etched** | **3 µm etched** | **4 µm etched** | **25 µm etched** |
| **Average (MPa)** | 680 | 716 | 843 | 868 | -- |
| **Std Dev (MPa)** | 137 | 425 | 399 | 357 | -- |
| **Max (MPa)** | 863 | 1851 | 1608 | 1583 | -- |
| **Min (MPa)** | 316 | 213 | 365 | 344 | -- |
| **Range (MPa)** | 547 | 1638 | 1244 | 1240 | -- |
| **Coeff of variance** | 0.20 | 0.59 | 0.47 | 0.41 | -- |

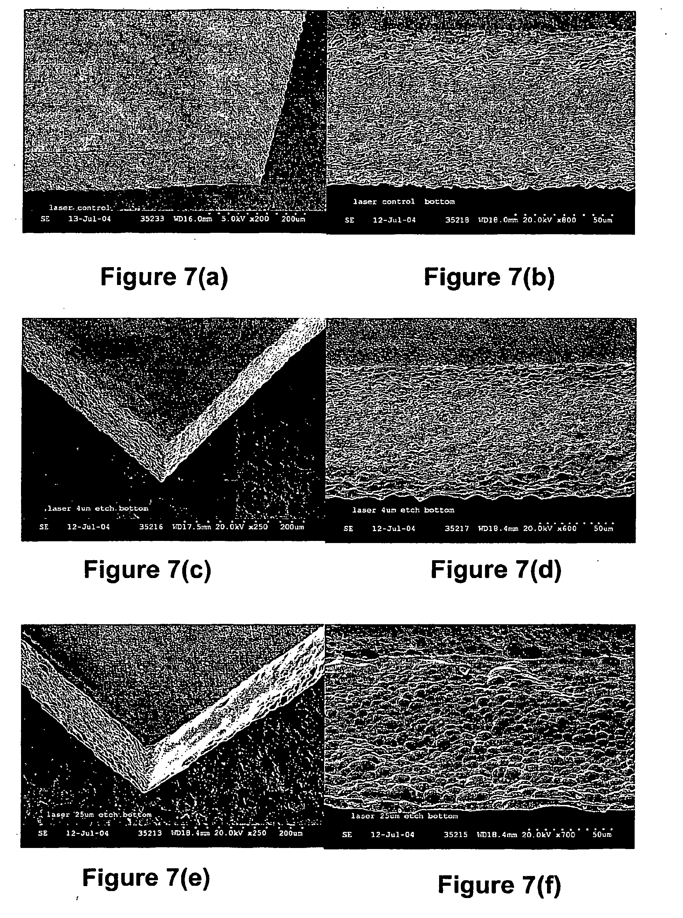

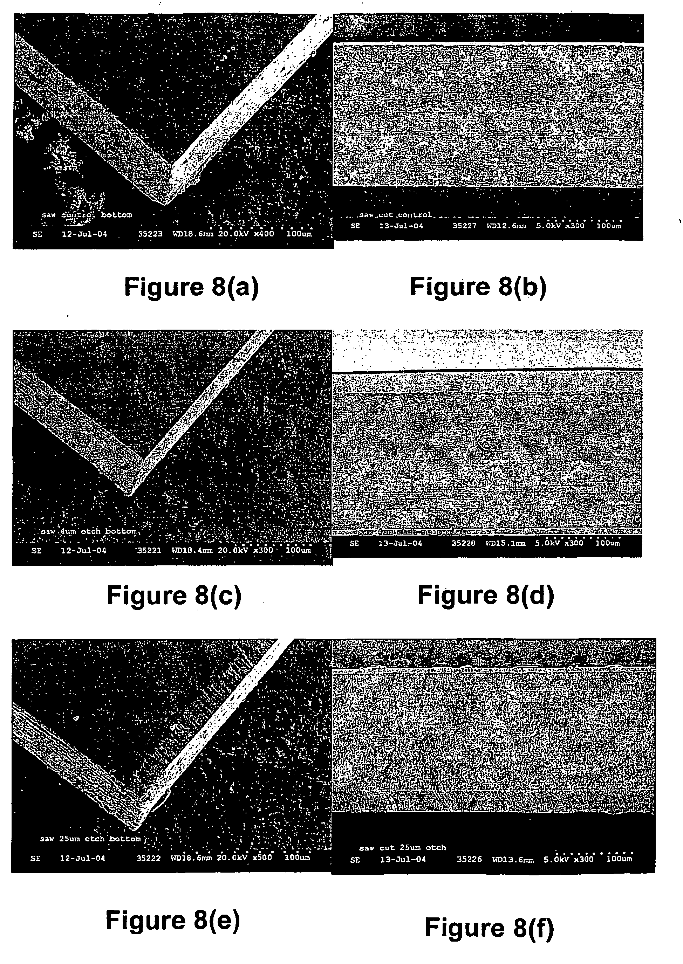

SEM images of the laser-cut and saw-cut wafers are shown in Figures 7 and 8 respectively. Figure 7(a) shows a laser-cut un-etched die corner at x200 magnification, Figure 7(b) shows a laser-cut un-etched sidewall at x800 magnification, Figure 7(c) shows a laser-cut die corner etched 4 µm at x250 magnification, Figure 7(d) shows a laser-cut sidewall etched 4 µm at x600 magnification, Figure 7(e) shows a laser-cut die corner etched 25 µm at x250 magnification, Figure 7(f) shows a laser-cut sidewall etched 25 µm at x700 magnification. Figure 8(a) shows a saw-cut un-etched die corner at x400 magnification, Figure 8(b) shows a saw-cut un-etched sidewall at x300 magnification, Figure 8(c) shows a saw-cut die corner etched 4 µm at x300 magnification, Figure 8(d) shows a saw-cut sidewall with no resist etched 4 µm at x300 magnification, Figure 8(e) shows a saw-cut die corner etched 25 µm at x500 magnification, Figure 8(f) shows a saw-cut sidewall etched 25 µm at x300 magnification.

For both the 3-point and 4-point tests, it can be seen that for both saw-cut and laser-cut die, on average the etched dies had higher flexural strength than the un-etched dies and the flexural strength increases with depth of etch in the etch range 2 µm to 25 µm.

## Claims

1. A method of dicing a semiconductor wafer (11) having an active layer on a major surface of the wafer, the method comprising the steps of:
a. mounting the semiconductor wafer on a carrier (13) with the active layer away from the carrier;
b. dicing the semiconductor wafer completely through the semiconductor wafer on the carrier from the major surface of the semiconductor wafer to form a diced semiconductor wafer (111) or partially dicing the semiconductor wafer along dicing lanes (18) to leave portions of semiconductor material bridging the dicing lanes; and
c. etching the diced semiconductor wafer, or the partially diced semiconductor wafer respectively, on the carrier from the said major surface with a spontaneous etchant (140), formed through dissociation of xenon difluoride in an etching chamber without use of an external energy source, to a predetermined etch depth in the range 2 µm to 25 µm to produce a predetermined increase in flexural bend strength of resultant die, the step of etching comprising etching sidewalls of the die, and additionally, in the case of partially dicing the semiconductor wafer, comprises etching away the portions of semiconductor material bridging the dicing lanes to singulate die;
**characterised in that** remaining portions of the die are masked from the spontaneous etchant by portions of the active layer on the die.

2. A method as claimed in claim 1, wherein the semiconductor wafer is a silicon wafer.

3. A method as claimed in claim 1, wherein the step of etching with a spontaneous etchant within the etching chamber comprises cyclically supplying the chamber with spontaneous etchant and purging the etching chamber of spontaneous etchant for a plurality of cycles during etching of the semiconductor wafer.

4. A method as claimed in claim 1, wherein the step of etching with a spontaneous etchant within the etching chamber comprises carrying out the etching as a continuous process.

## Patentansprüche

1. Verfahren zum Trennen eines Halbleiter-Wafers (11) mit einer aktiven Schicht auf einer Hauptoberfläche des Wafers, wobei das Verfahren die folgenden Schritte umfasst:
a) das Aufbringen des Halbleiter-Wafers auf einem Träger (13), wobei die aktive Schicht von dem Träger entfernt ist;
b) das Trennen des Halbleiter-Wafers vollständig durch den Halbleiter-Wafer an dem Träger von der Hauptoberfläche des Halbleiter-Wafers, so dass ein getrennter Halbleiter-Wafer (111) erzeugt wird, oder das teilweise Trennen des Halbleiter-Wafers entlang Trennspuren (18), so dass Teilstücke des Halbleitermaterials weiter die Trennspuren überbrücken; und
c) das entsprechende Ätzen des getrennten Halbleiter-Wafers oder des teilweise getrennten Halbleiter-Wafers auf dem Träger von der genannten Hauptoberfläche mit einem spontanen Ätzmittel (140), gebildet durch die Dissoziation von Xenondifluorid in einer Ätzkammer ohne den Einsatz einer externen Energiequelle bis auf eine vorbestimmte Ätztiefe im Bereich von 2 µm bis 25 µm, so dass eine vorbestimmte Erhöhung der Biegefestigkeit des resultierenden Chips erzeugt wird, wobei der Schritt des Ätzens das Ätzen von Seitenwänden des Chips umfasst, und wobei der Schritt für den Fall des teilweisen Trennens des Halbleiter-Wafers zusätzlich das Wegätzen der Teilstücke des Halbleitermaterials umfasst, das die Trennspuren überdrückt, um den Chip zu vereinzeln;
**dadurch gekennzeichnet, dass** die restlichen Teilstücke des Chips durch Teilstücke der aktiven Schicht auf dem Chip in Bezug auf das spontane Ätzmittel maskiert werden.

2. Verfahren nach Anspruch 1, wobei es sich bei dem Halbleiter-Wafer um einen Silizium-Wafer handelt.

3. Verfahren nach Anspruch 1, wobei der Schritt des Ätzens mit einem spontanen Ätzmittel in der Ätzkammer das zyklische Versorgen der Kammer mit spontanem Ätzmittel und das Spülen der Ätzkammer in Bezug auf das spontane Ätzmittel für eine Mehrzahl von Zyklen während dem Ätzen des Halbleiter-Wafers umfasst.

4. Verfahren nach Anspruch 1, wobei der Schritt des Ätzens mit einem spontanen Ätzmittel in der Ätzkammer das Ausführen des Ätzens als einen ununterbrochenen Prozess umfasst.

## Revendications

1. Procédé de découpage en puces d'une tranche semi-conductrice (11) ayant une couche active sur une surface majeure de la tranche, le procédé comprenant les étapes consistant à :
a. monter la tranche semi-conductrice sur un porteur de charge (13) avec la couche active loin du porteur de charge ;
b. découper en puces la tranche semi-conductrice complètement à travers la tranche semi-conductrice sur le porteur de charge à partir de la surface majeure de la tranche semi-conductrice pour former une tranche semi-conductrice découpée en puces (111) ou découper partiellement en puces la tranche semi-conductrice le long de voies de découpage en puces (18) pour laisser des parties de matériau semi-conducteur entre les voies de découpage en puces ; et
c. attaquer la tranche semi-conductrice découpée en puces, ou la tranche semi-conductrice partiellement découpée en puces, sur le porteur de charge à partir de ladite surface majeure avec un agent d'attaque spontané (140), formé par dissociation de difluorure de xénon dans une chambre d'attaque sans utiliser une source d'énergie externe, à une profondeur d'attaque prédéterminée dans la plage de 2 à 25 µm pour produire une augmentation prédéterminée de la résistance au pliage par flexion de la puce obtenue, l'attaque comprenant les étapes consistant à attaquer les parois latérales de la puce et, en outre, en cas de découpage en puces partiel de la tranche semi-conductrice, à attaquer les parties de matériau semi-conducteur reliant les voies de découpage en puces pour séparer la puce ;
**caractérisé en ce que** les parties restantes de la puce sont masquées de l'agent d'attaque spontané par des parties de la couche active sur la puce.

2. Procédé selon la revendication 1, dans lequel la tranche semi-conductrice est une. tranche de silicium.

3. Procédé selon la revendication 1, dans laquelle l'attaque avec un agent d'attaque spontané dans la chambre d'attaque comprend les étapes consistant à fournir de manière cyclique à la chambre un agent d'attaque spontané et à purger la chambre d'attaque de l'agent d'attaque spontané pour une pluralité de cycles lors de l'attaque de la tranche semi-conductrice.

4. Procédé selon la revendication 1, dans lequel l'attaque avec un agent d'attaque spontané dans la chambre d'attaque comprend l'étape consistant à effectuer l'attaque comme un processus continu.
